# EUROPÄISCHE PATENTSCHRIFT

(11) **EP 0 620 868 B1**
(45) Veröffentlichungstag und Bekanntmachung des Hinweises auf die Patenterteilung: **28.06.1995**
(21) Anmeldenummer: 93902144.0
(22) Anmeldetag: 06.01.1993
(51) Int. Cl.: C23C 14/32, H01J 37/32

(54) **VERFAHREN ZUR IONISATION THERMISCH ERZEUGTER MATERIALDÄMPFE UND VORRICHTUNG ZUR DURCHFÜHRUNG DES VERFAHRENS**
PROCESS FOR IONISING THERMALLY GENERATED MATERIAL VAPOURS AND DEVICE FOR IMPLEMENTING IT
PROCEDE ET DISPOSITIF D'IONISATION DE VAPEURS DE MATERIAUX PRODUITES PAR VOIE THERMIQUE

(30) Priorität: 10.01.1992 DE 4200429
(43) Veröffentlichungstag der Anmeldung: 26.10.1994
(73) Patentinhaber: Plasco Dr. Ehrich Plasma-Coating GmbH, 55262 Heidesheim (DE)
(72) Erfinder: EHRICH, Horst, D-4270 Dorsten 11 (DE)
(74) Vertreter: Werner, Hans-Karsten, Dr.Dipl.-Chem.
(86) Internationale Anmeldenummer: EP9300009
(87) Internationale Veröffentlichungsnummer: WO9314240

(56) Entgegenhaltungen:
- EP-A- 0 385 283
- DE-A- 4 042 337
- MATERIALS SCIENCE AND ENGINEERING, A Bd. A140, 1991, THE NETHERLANDS Seiten 825- 829 M. MAUSBACH ET AL 'RELATIONS BETWEEN PLASMA PROPERTIES AND PROPERTIES OF THIN COPPER FILMS PRODUCED BY AN ANODIC VACUUM ARC"

## Beschreibung

Gegenstand der vorliegenden Erfindung ist ein Verfahren zur Ionisation von bei Unterdruck thermisch erzeugten Materialdämpfen sowie eine Vorrichtung zur Durchführung des Verfahrens.

Es ist allgemein bekannt, daß die Verwendung von ionisierten Materialdämpfen bei der Beschichtung von Substraten aus der Dampfphase eine deutliche Verbesserung vieler Schichteigenschaften bewirkt. Insbesondere lassen sich durch Anwendung der plasma- und ionengestützten Verfahren eine größere Haftfestigkeit der Beschichtung auf Substratoberflächen sowie eine größere Kompaktheit des Schichtaufbaus erzielen. Weiterhin besteht die Möglichkeit, reaktive Beschichtungsprozesse durchzuführen.

Zur Erzeugung ionisierter Materialdämpfe werden elektrische Entladungen eingesetzt. Man unterscheidet hier nach physikalischen Gesichtspunkten zwischen Glimmentladungen und Lichtbogenentladungen.

Zu den Glimmentladungen ist die Kathodenzerstäubung (Sputtern) zu zählen. Bei den Lichtbogenentladungen unterscheidet man prozeßgasgebundene Entladungen mit Hohlkathoden gemäß US-A-3,562,141 oder Glühkathoden gemäß US-A-4,197,175 sowie Vakuumlichtbogenentladungen mit selbstverzehrender Kathode gemäß US-A-4,563,262 oder selbstverzehrender Kathode und heißer selbstverzehrender Anode gemäß US-A-4,917,786.

Weiterhin ist aus der DE-A-40 42 337 eine Vakuumlichtbogenentladung mit kontrolliert einstellbarem Ionisationsgrad bekannt. Bei dem dort beschriebenen Verfahren zur Steuerung des Ionisationsgrades sind Aufdampfrate und Ionisationsgrad stark miteinander gekoppelt. Weiterhin erfordert die dort beschriebene Steuerung des Ionisationsgrades mechanische Bewegungen im Vakuum.

Allen vorgenannten Verfahren ist gemeinsam, daß das Verdampfungsmaterial in spezieller verfahrensspezifischer Weise angeordnet sein muß. Konventionelle thermische Verdampfer sind nicht Bestandteil der aufgeführten Verfahren. Zu diesen zählen widerstands- oder induktivbeheizte Tiegel bzw. Verdampferwendeln sowie die Materialverdampfung mit Hilfe eines Elektronenstrahls. Von thermischen Verdampfern erzeugte Materialdämpfe sind nicht ionisiert. Zur Ionisierung dieser Materialdämpfe sind bereits mehrere Methoden bekannt.

Die DE-A-39 31 565 beschreibt eine Methode, nach der dem thermisch erzeugten Dampf Ionen eines gasförmigen Ausgangsmaterials, typischerweise Argon oder Stickstoff, beigemischt werden. Diese Ionen werden in einer separaten Ionenquelle erzeugt. Hier handelt es sich daher nicht um eine Ionisierung des Materialdampfes, sondern um Materialdampf, dem Ionen einer gasförmigen Ausgangssubstanz beigemischt werden.

Die US-A-4,039,416 sowie die US-A-4,342,631 beschreiben Verfahren zur Erzeugung ionisierter Materialdämpfe, bei denen die Materialdämpfe mittels thermischer Verdampfung erzeugt werden (Induktions- bzw. Widerstandsheizung). Die Ionisierung dieser Materialdämpfe in der Umgebung des zu beschichtenden Werkstücks erfolgt durch die Einkoppelung hochfrequenter elektromagnetischer Wellen (RF-Heizung). Vorteil dieser Methode ist, daß ohne Anwendung eines Prozeßgases ein reines Plasma des Materialdampfes entsteht. RF-Entladungen sind jedoch insbesondere im größeren industriellen Maßstab schwer zu beherrschen und erfordern zur Vermeidung von Störstrahlung Abschirmmaßnahmen.

Aus der US-A-3,756,193 sowie der US-A-4,461,689 ist weiterhin ein Verfahren bekannt, bei dem der durch einen Elektronenstrahl thermisch erzeugte Materialdampf mit Hilfe einer Gleichstrom-Glimmentladung ionisiert wird. Zur Aufrechterhaltung dieser Glimmentladung muß dem Materialdampf ein Prozeßgas zugemischt werden. Das Prinzip dieses "Ion-plating" genannten Verfahrens wurde erstmals in der US-A-3,329,601 beschrieben.

Nachteilig beim Ion-plating ist, daß dieses Verfahren praktisch auf den Labormaßstab begrenzt ist. Mit zunehmender Größe der Verdampfungsapparatur oder der Substratoberfläche nimmt bei Gleichstrom-Glimmentladungen die Tendenz, in eine Lichtbogenentladung umzuschlagen, stark zu. Bei einer kritischen Größe der Apparatur und damit oberhalb eines kritischen Wertes des Entladungsstromes ist der Lichtbogen immer die gegenüber der Glimmentladung bevorzugte Entladungsform. Der Umschlag in eine Lichtbogenentladung kann zu erheblichen Schäden an der Dampfquelle oder dem Substrat führen. Weiterhin nachteilig ist die Verwendung von Hochspannung sowie die Anwendung eines Prozeßgases, das häufig die Qualität der Beschichtung negativ beeinflußt.

Die US-A-4,448,802 beschreibt ein Verfahren, bei dem ein mittels Elektronenstrahl verdampftes Material mit Hilfe eines Niedervoltbogens ionisiert wird. Dieser Niedervoltbogen ist prozeßgasgebunden und wird betrieben zwischen dem das Verdampfungsmaterial enthaltenden Tiegel sowie einer Glühkathode. Diese Glühkathode befindet sich wegen des in der Kathodenregion notwendigen Prozeßgasdruckes in einer separaten Kathodenkammer, die über eine als Druckstufe ausgelegte Öffnung mit dem Verdampfungsraum verbunden ist. Die verfahrenstechnisch notwendige Anwendung eines Prozeßgases führt zu einer häufig unerwünschten Beteiligung dieses Prozeßgases bei der Schichtbildung.

Die EP-A-0 385 283 beschreibt ein Verfahren zur Beschichtung von Hartmetallgrundkörpern, bei dem die Oberflächen mit einer mittels Ionenplattierung aufgebrachten Unterschicht versehen sind. Über der Unterschicht ist eine durch anschließende chemische Bedampfung erzeugte Oberschicht angeordnet. Gemäß Spalte 4, Z. 7 ff. erfolgt die Materialionisierung mittels eines Lichtbogens der Niedervoltbogenentladung. Dieser Niedervoltbogen ist prozeßgasgebunden (Sp. 4, Z. 35 bis 38). Er wird betrieben zwischen dem das Verdampfungsmaterial enthaltenden Tiegel (9) und einer Glühkathode (49), die sich wegen des in der Kathodenregion notwendigen Prozeßgasdruckes in einer separaten Kathodenkammer (8) befindet. Somit handelt es sich hierbei um einen mit der US-A-4,448,802 vergleichbaren Stand der Technik. Die Anwendung eines prozeßgasgebundenen Niedervoltbogens führt im Vergleich zum Vakuumlichtbogen zu einer erheblich verschlechterten Schichtbildung beim Aufdampfprozeß durch Beteiligung des in jedem Falle vorhandenen Prozeßgases.

Das technische Problem der vorliegenden Erfindung war somit, ein Verfahren zu entwickeln, das den mit konventionellen thermischen Verdampfern erzeugten Materialdampf ionisiert und dabei die oben beschriebenen Nachteile - beispielsweise die Anwendung eines Prozeßgases, die Einkoppelung hochfrequenter elektromagnetischer Wellen und die Anwendung von Hochspannung - vermeidet, leicht in bereits bestehende thermische Verdampfungsapparaturen integriert werden kann und im großen industriellen Maßstab einsetzbar ist.

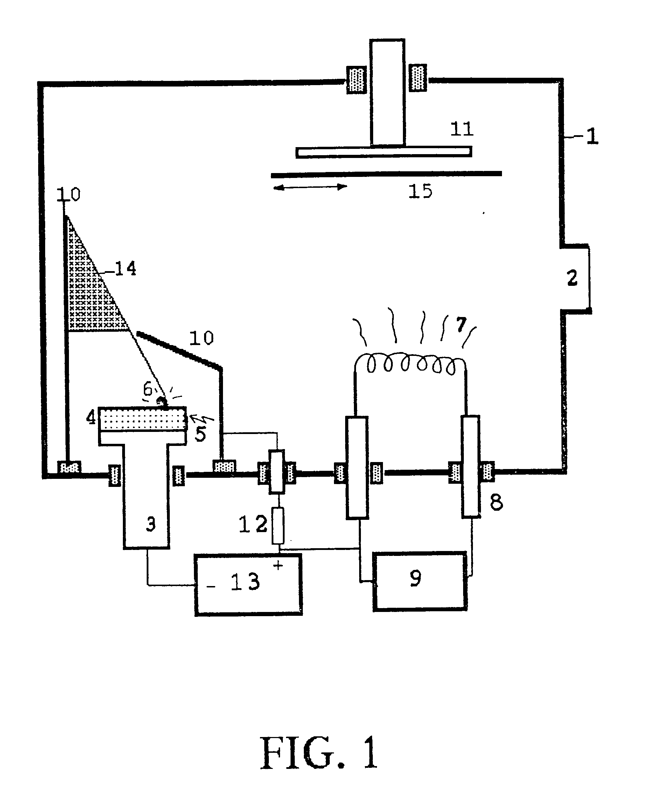

Dieses technische Problem wird gelöst durch ein Verfahren zur Ionisation von bei Unterdruck thermisch erzeugten Materialdämpfen, wobei die Materialdämpfe den Elektronen aus den Kathodenflecken (6) einer selbstverzehrenden kalten Kathode (3, 4) ausgesetzt werden, wobei die thermische Verdampfungsvorrichtung (7) als Anode geschaltet wird, so daß sich zwischen Kathode (3, 4) und Anode (7) eine Vakuum-Lichtbogenentladung ausbildet, das dadurch gekennzeichnet ist, daß die Abdampfgeschwindigkeit der Verdampfungsvorrichtung (7) durch die Energiezufuhr aus dem Versorgungsgerät (9) bestimmt wird, während die Ionisation durch den im Lichtbogen zwischen Kathode (4) und Anode (7) fließenden Bogenstrom bestimmt wird. In einer bevorzugten Ausführungsform ist der von den Kathodenflecken ausgehende Plasmastrom durch eine die Kathode umgebende Wandung 10 von der thermischen Verdampfungsvorrichtung 7 abgeschirmt (s. Fig. 1).

In einer weiteren bevorzugten Ausführungsform wird der in der Kathode erzeugte Plasmastrom auf die abschirmende Wandung 10 gerichtet. Die Wandung 10 kann als Hilfsanode geschaltet werden.

Ein weiterer Gegenstand der Erfindung ist eine Vorrichtung zur Durchführung des oben beschriebenen Verfahrens (Fig. 1), wobei in einer Unterdruckkammer 1 eine kühlbare Kathodenhalterung 3 mit dem darauf aufgebrachten Kathodenmaterial 4 zur Erzeugung von Kathodenflecken auf der selbstverzehrenden kalten Kathode, ein als Anode geschaltetes thermisches Materialverdampfungssystem 7, 8, 9 und eine die Kathode umgebende, als Hilfsanode geschaltete Wandung 10, die der Kathode gegenüberliegend eine Öffnung besitzt, angeordnet sind. An der Kathode ist eine Zündvorrichtung 5 angeordnet.

In einer bevorzugten Ausführungsform ist in der Unterdruckkammer 1 ein mit dem ionisierten Materialdampf zu beschichtendes Material 11, das mit einer verschiebbaren Blende 15 abdeckbar ist, angeordnet.

Das erfindungsgemäße Verfahren ist im einzelnen wie folgt beschrieben:
Nach Einschalten des Versorgungsgerätes 13 werden über den Zündmechanismus 5 Kathodenflecken 6 auf dem Kathodenmaterial 4 erzeugt. Zwischen der Kathode 4 und der als Hilfsanode geschalteten Wandung 10 entsteht ein Hilfslichtbogen. Zur gleichen Zeit wird das thermische Verdampfungssystem 7 mit Hilfe der Energieversorgung 9 aktiviert, so daß das mit der Verdampfungsvorrichtung verbundene Material verdampfen kann. Das Verdampfungssystem 7, als Hauptanode geschaltet, liegt infolge des Spannungsabfalls über dem Widerstand 12 stets auf einem positiveren Potential als die Hilfsanode 10. Daher werden aus dem Bereich 14 Elektronen zum Verdampfungssystem 7 beschleunigt. Diese Elektronen ionisieren über inelastische Stöße den vom Verdampfungssystem 7 abströmenden Materialdampf, so daß sich insbesondere im Bereich großer Dampfdichte in der Umgebung von 7 ein intensives anodisches Plasma ausbildet. Die Ionisierung dieses Plasmas wird wesentlich durch die Bereitstellung von Elektronen im Bereich 14 beeinflußt, d.h. durch die Ladungsträgerdichte im kathodischen Plasmastrom.

Bei genügend hoher Ionisation am Verdampfungssystem 7 entsteht eine eigenständige Lichtbogenentladung zwischen der Kathode 4 und der Anode 7. Dem Bereich 14 kommt dabei die Funktion eines "Elektronenlieferanten" zu. Damit kann der Bereich 14 auch als "virtuelle Kathode" angesehen werden. Das aus der Plasmawolke um 7 abströmende Plasma kann für Beschichtungszwecke genutzt werden. Da kein Prozeßgas verwendet wird, wird die Ionisation des Materialdampfes bis in große Entfernungen (etwa 1 m) vom Verdampfungssystem beibehalten. Nach Ausbildung des Lichtbogens zwischen Kathode 4 und Anode 7 können durch Regelung der Energieversorgung 9 des thermischen Verdampfungssystems 7 die Abdampfrate und durch Regelung des Versorgungsgerätes 13 der Ionisationsgrad praktisch unabhängig voneinander eingestellt werden. Dabei tritt eine zusätzliche Aufheizung des Verdampfungsmaterials durch die auf das Verdampfungssystem 7 auftreffenden Elektronen ein. Nachdem die vorgegebenen Verfahrensparameter hinsichtlich der Aufdampfrate und der Ionisation erreicht sind, kann eine Beschichtung des Substrates 11 mit dem erzeugten Plasma nach Entfernen der das Substrat 11 bedeckenden verschiebbaren Blende 15 erfolgen.

Während des Beschichtungsprozesses können Aufdampfrate und Ionisation nach einem festen Programm kontrolliert und verändert werden. Da kein Prozeßgas verwendet wird, wird auch das Schichtwachstum nicht gestört.

Die in der Umgebung der thermischen Verdampfungsvorrichtung 7 entstehenden Ionen können durch Anlegen einer Bias-Spannung beschleunigt werden. Eine Beschleunigung der Ionen in Richtung des Substrats ist sowohl bei elektrisch leitfähigen wie bei elektrisch nicht leitfähigen Substraten möglich (siehe auch H. Ehrich et al., "IEEE-Transactions on Plasma Science", Vol. 18, Nr. 6, 895, Dezember 1990).

Nachdem das Verdampfungsmaterial im Verdampfungssystem 7 verbraucht ist, verlöscht der Lichtbogen von selbst, da zwischen dem Bereich 14 und der Wandung 10 und der thermischen Verdampfungsvorrichtung 7 kein Plasma mehr vorhanden ist. Das verbrauchte Verdampfungsmaterial kann dem Verdampfungssystem 7 während des Beschichtungsprozesses zugeführt werden. Die Kathode 3, 4 kann hinsichtlich ihrer geometrischen Form und Größe sowie des Materials sehr flexibel ausgelegt werden, so daß sowohl lange Standzeiten der Kathode als auch ein sicherer Betrieb des Lichtbogens erreicht werden.

Das erfindungsgemäße Verfahren ionisiert den mit konventionellen thermischen Verdampfern erzeugten Materialdampf, wobei eine kontrolliert einstellbare Ionisation dieses Materialdampfes möglich ist und gleichzeitig eine vom Ionisationsgrad unabhängige Einstellung der Abdampfrate gestattet wird. Eine Kontamination des Materialdampfes wird durch die Abdeckung der Kathode vermieden.

Es kann ohne die Anwendung eines Prozeßgases, die Anwendung von Hochspannung und Hochfrequenz gearbeitet werden.

Das erfindungsgemäße Verfahren kann durch kostengünstige Umrüstung bereits bestehender Vakuum-Verdampfungsapparaturen in diesen durchgeführt werden. Es ist in großem industriellen Maßstab einsetzbar und ist den bisherigen Verfahren insbesondere dadurch überlegen, daß eine unabhängige Steuerung des Ionisationsgrades und der Abdampfrate ermöglicht wird. Das erfindungsgemäße Verfahren entkoppelt nämlich die Dampferzeugung und die Ionisierung des Dampfes weitgehend. Die Abdampfgeschwindigkeit vom Verdampfungssystem 7 wird im wesentlichen durch die Energiezufuhr aus dem Versorgungsgerät 9 bestimmt, während die Ionisation durch den im Lichtbogen zwischen der Kathode 4 und der Anode 7 fließenden Bogenstrom eingestellt wird. Der Lichtbogenbetrieb über die "virtuelle Kathode" 14 gewährleistet darüber hinaus die Entkoppelung der Materialströme von Kathode 4 und Anode 7. Diese Entkoppelung verhindert eine Kontamination des von der Anode 7 abströmenden Plasmas mit Kathodenmaterial, sofern unterschiedliche Materialien an der Kathode 4 und an der Anode 7 verwendet werden. Der Stromfluß im Lichtbogen wird dadurch aufrechterhalten, daß sich das kathodische und anodische Plasma berühren und damit eine elektrisch leitende Verbindung zwischen den Elektroden erzeugt und aufrechterhalten wird. Diese Vorteile sind insbesondere im Hinblick auf einen automatisierten Prozeßablauf in großtechnischem Maßstab von Vorteil.

Figur 1 zeigt eine Vorrichtung zur Durchführung des erfindungsgemäßen Verfahrens.

Dargestellt ist eine Unterdruckkammer 1, die über einen Pumpstutzen 2 evakuierbar ist. In der Unterdruckkammer ist - von dieser elektrisch isoliert - eine kühlbare Kathodenhalterung 3, die an ihrem vorderen Ende das Kathodenmaterial 4 aufnimmt, angeordnet. Mit Hilfe der Zündvorrichtung 5 können auf der Arbeitsfläche der Kathode Kathodenflecken 6 erzeugt werden, die mit bekannten Methoden auf den Bereich der Kathodenarbeitsfläche fixiert werden. Zu diesen bekannten Methoden zählen die Anwendung von Magnetfeldern (gemäß US-A-4,551,221) oder die Begrenzung der Arbeitsfläche durch ein geeignetes Material (gemäß DE-A-40 42 337).

Die Unterdruckkammer enthält weiterhin ein thermisches Verdampfungssystem 7, 8, 9, das in Figur 1 beispielhaft als Verdampferwendel 7 dargestellt ist, die über elektrisch isolierte Durchführungen 8 mit einem elektrischen Versorgungsgerät 9 verbunden ist. Anstelle der in Figur 1 beispielhaft dargestellten Verdampferwendel 7 kann jedes bekannte thermische Verdampfersystem - wie widerstands- oder induktivbeheizte Tiegel sowie durch Elektronen- oder Laserstrahl aufgeheizte Materialien - verwendet werden.

Die Kathode 4 ist von Wandungen 10 umgeben, auf denen das von den Kathodenflecken 6 aus dem Kathodenmaterial 4 abgelöste Material kondensiert. Die Wandungen 10 sind so ausgebildet, daß das von den Kathodenflecken 6 abgelöste Material sowohl vom Verdampfer 7 als auch vom Substrat 11 ferngehalten wird, um eine Kontamination der Anode 7 bzw. des zu beschichtenden Materials 11 durch Kathodenmaterial zu vermeiden.

Weiterhin dient die Wandung 10 oder ein Teil derselben als Hilfsanode zur Zündung und Aufrechterhaltung der Lichtbogenentladung. Hierzu ist die Wandung 10 elektrisch isoliert von der Unterdruckkammer angeordnet und über einen Widerstand 12 von vorzugsweise 0,3 bis 1 Ohm mit dem positiven Ausgang des Lichtbogenversorgungsgerätes 13 verbunden. Es ist auch möglich, die Wandung 10 mit der Unterdruckkammer 1 elektrisch zu verbinden. In diesem Fall verbindet der Widerstand 12 den positiven Ausgang des Lichtbogenversorgungsgerätes 13 mit der Unterdruckkammer.

Die Wandung 10 ist so ausgebildet, daß der von den Kathodenflecken 6 ausgehende Plasmastrom durch Öffnungen in einen Bereich 14 der Unterdruckkammer gelangt, in dem sich von den Kathodenflecken ausgehende Plasmaströme und von dem Verdampfer ausgehende Materialströme treffen.

Die Blende 15 ermöglicht die Abschattung von Einschalt- und Abschaltvorgängen am zu beschichtenden Substrat 11.

Bei der Durchführung des erfindungsgemäßen Verfahrens ist zu beachten, daß sich unter Umständen die Versorgungsgeräte 9, 13 gegenseitig beeinflussen. Diese Beeinflussung kann durch geeignete elektrische Schaltungsmaßnahmen zwischen den Versorgungsgeräten vermieden werden. Notwendigkeit und Art dieser Schaltungsmaßnahmen sind abhängig von den in den Versorgungsgeräten 9, 13 angewandten Prinzipien zur Erzeugung der Versorgungsspannungen.

Das erfindungsgemäße Verfahren und die erfindungsgemäße Vorrichtung zur Durchführung des Verfahrens können insbesondere zur Beschichtung von Oberflächen mit ionisierten Materialdämpfen im Vakuum verwendet werden.

## Patentansprüche

1. Verfahren zur Ionisation von bei Unterdruck thermisch erzeugten Materialdämpfen, wobei die Materialdämpfe den Elektronen aus den Kathodenflecken (6) einer selbstverzehrenden kalten Kathode (3, 4) ausgesetzt werden, wobei die thermische Verdampfungsvorrichtung (7) als Anode geschaltet wird, so daß sich zwischen Kathode (3, 4) und Anode (7) eine Vakuum-Lichtbogenentladung ausbildet, dadurch gekennzeichnet, daß die Abdampfgeschwindigkeit der Verdampfungsvorrichtung (7) durch die Energiezufuhr aus dem Versorgungsgerät (9) bestimmt wird, während die Ionisation durch den im Lichtbogen zwischen Kathode (4) und Anode (7) fließenden Bogenstrom bestimmt wird.

2. Verfahren nach Anspruch 1, dadurch gekennzeichnet, daß der von den Kathodenflecken ausgehende Plasmastrom durch eine die Kathode umgebende Wandung (10) von der thermischen Verdampfungsvorrichtung (7) abgeschirmt wird.

3. Verfahren nach Anspruch 1 oder 2, dadurch gekennzeichnet, daß der Plasmastrom auf die abschirmende Wandung (10) gerichtet wird.

4. Verfahren nach Ansprüchen 1 bis 3, dadurch gekennzeichnet, daß die Wandung (10) als Hilfsanode geschaltet wird.

5. Vorrichtung zur Durchführung des Verfahrens nach Ansprüchen 1 bis 4, wobei in einer Unterdruckkammer (1) eine kühlbare Kathodenhalterung (3) mit dem darauf aufgebrachten Kathodenmaterial (4) zur Erzeugung von Kathodenflecken auf der selbstverzehrenden kalten Kathode, ein als Anode geschaltetes thermisches Materialverdampfungssystem (7, 8, 9) und eine die Kathode umgebende, als Hilfsanode geschaltete Wandung (10), die der Kathode gegenüberliegend eine Öffnung besitzt, angeordnet sind.

6. Vorrichtung nach Anspruch 5, dadurch gekennzeichnet, daß an der Kathode eine Zündvorrichtung (5) angeordnet ist.

7. Vorrichtung nach Anspruch 5 oder 6, dadurch gekennzeichnet, daß in der Unterdruckkammer (1) ein mit dem ionisierten Materialdampf zu beschichtendes Material (11) angeordnet ist.

## Claims

1. A process for ionizing material vapors generated thermally at reduced pressure, wherein the material vapors are exposed to electrons from the cathode spots (6) of a self-consuming cold cathode (3, 4), the thermal vaporization device (7) being connected as an anode, so that a vacuum arc discharge forms between cathode (3, 4) and anode (7), which process is characterized in that the evaporation rate of the vaporization device (7) is determined by the energy supply from the supply unit (9), while the ionization is determined by the arc current flowing through the arc between cathode (4) and anode (7).

2. The process according to claim 1, characterized in that the plasma stream emerging from the cathode spots is shielded from the thermal vaporization device (7) by a wall (10) surrounding the cathode.

3. The process according to claim 1 or 2, characterized in that the plasma stream is directed onto the shielding wall (10).

4. The process according to claims 1 to 3, characterized in that the wall (10) is connected as an auxiliary anode.

5. A device for operating the process according to claims 1 to 4, wherein in a vacuum chamber (1) there is arranged a cathode holder (3) that can be cooled, having the cathode material (4) applied thereon for generating cathode spots on the self-consuming cold cathode, a thermal material vaporization system (7, 8, 9) connected as an anode, a wall 10 surrounding the cathode and connected as an auxiliary anode, which wall has an opening opposite the cathode.

6. The device according to claim 5, characterized in that an ignition device (5) is arranged at the cathode.

7. The device according to claim 5 or 6, characterized in that there is arranged in the vacuum chamber (1) a material (11) to be coated with the ionized material vapor.

## Revendications

1. Procédé d'ionisation de vapeurs de matériaux produites sous vide par voie thermique, dans lequel les vapeurs de matériaux sont exposées aux électrons provenant des taches cathodiques (6) d'une cathode froide (3, 4) autoconsommable, le dispositif d'évaporation thermique (7) étant monté dans le circuit en constituant une anode, de sorte qu'une décharge à arc électrique sous vide est formée entre la cathode (3, 4) et l'anode (7), caractérisé en ce que la vitesse de départ de la vapeur s'échappant du dispositif d'évaporation (7) est déterminée par l'amenée d'énergie en provenance de l'appareil d'alimentation (9), tandis que l'ionisation est déterminée par le courant d'arc passant dans l'arc électrique entre la cathode (4) et l'anode (7).

2. Procédé selon la revendication 1, caractérisé en ce que le courant de plasma partant des taches cathodiques est protégé du dispositif (7) d'évaporation thermique par une paroi (10), entourant la cathode.

3. Procédé selon la revendication 1 ou 2, caractérisé en ce que le courant de plasma est dirigé vers la paroi (10) formant protection.

4. Procédé selon les revendications 1 à 3, caractérisé en ce que la paroi (10) est reliée au circuit en constituant une anode auxiliaire.

5. Dispositif pour la mise en oeuvre du procédé selon les revendications 1 à 4, dans lequel sont disposés, dans une chambre à vide (1), un porte-cathode (3) pouvant être refroidi, sur lequel est appliqué le matériau cathodique (4) destiné à produire des taches cathodiques sur la cathode froide autoconsommable, un système thermique (7, 8, 9) d'évaporation de matériau, connecté au circuit de façon à constituer une anode, et une paroi (10) entourant la cathode et connectée au circuit de façon à constituer une anode auxiliaire, qui présente une ouverture située en face de la cathode.

6. Dispositif selon la revendication 5, caractérisé en ce qu'un dispositif d'allumage (5) est prévu sur la cathode.

7. Dispositif selon la revendication 5 ou 6, caractérisé en ce qu'un objet (11) à revêtir de la vapeur ionisée de matériau est disposé dans la chambre à vide (1).
